# EUROPEAN PATENT SPECIFICATION

(11) **EP 3 361 472 B1**
(45) Date of publication and mention of the grant of the patent: **30.12.2020**
(21) Application number: 16852863.6
(22) Date of filing: 30.09.2016
(51) Int. Cl.: G11C 19/18, G11C 19/28, G09G 3/36, G11C 29/02, G11C 29/00

(54) **SHIFT REGISTER UNIT, GATE LINE DRIVING APPARATUS AND DRIVING METHOD**
SCHIEBEREGISTEREINHEIT, ANSTEUERUNGSVORRICHTUNG FÜR GATE-LEITUNG UND ANSTEUERUNGSVERFAHREN
UNITÉ DE REGISTRE À DÉCALAGE, APPAREIL DE COMMANDE DE LIGNE DE GRILLE ET PROCÉDÉ DE COMMANDE

(30) Priority: 08.10.2015 CN 201510647045
(43) Date of publication of application: 15.08.2018
(73) Proprietor: BOE Technology Group Co., Ltd., Beijing 100015 (CN); Beijing BOE Display Technology Co., Ltd., Beijing 100176 (CN)
(72) Inventor: WANG, Zheng, Beijing 100176 (CN)
(74) Representative: Klunker IP Patentanwälte PartG mbB
(86) International application number: PCT/CN2016/101109
(87) International publication number: WO 2017/059792

(56) References cited:
- CN-A- 104 658 505
- CN-A- 104 700 812
- CN-A- 104 700 814
- CN-A- 104 715 733
- CN-A- 105 185 339
- CN-U- 204 966 019
- US-A1- 2009 040 161
- US-A1- 2010 214 206
- US-A1- 2012 320 008
- US-A1- 2015 187 313

## Description

### TECHNICAL FIELD

The present invention relates to the technical field of display technology, and more particularly to a shift register unit, a gate line driving device comprising the shift register unit, and a driving method for being applied to the shift register unit.

### BACKGROUND

In the field of display technology, an array of pixels of a liquid crystal display typically includes a plurality of rows of gate lines and a plurality of columns of data lines crossed with each other, wherein driving of the gate lines can be implemented through an attached integrated driving circuit. In recent years, with continuous development of the amorphous silicon thin film manufacturing process, a gate driving circuit can also be integrated on a thin film transistor array substrate so as to form a GOA (Gate driver On Array) for driving the gate lines.

A plurality of shift register units can be adopted to form the GOA to provide a switching signal to a plurality of rows of gate lines of a pixel array, so as to control the plurality of rows of gate lines to be turned on sequentially, and the data lines apply display data signals to pixels in the corresponding rows in the pixel array, so as to form grayscale voltages required to display respective gray scales of an image, and then each frame of the image is displayed.

In an existing gate line driving device, after the shift register unit in a current stage completes its output, in order to reset an output terminal of the shift register unit in the current stage, an output signal from an shift register unit in a next stage is typically taken as a reset signal for the shift register unit in the current stage to control a pull-down transistor, so as to reset the output terminal of the shift register unit in the current stage. However, the transistor that pulls down the output terminal of the shift register unit usually has a large size and a low use efficiency, which is inimical to circuit downsizing and power consumption reducing. Meanwhile, resetting of the shift register unit in a previous stage and triggering of the shift register unit in a next stage are both completed through a signal outputted from an output transistor of the shift register unit in the current stage, thus the output transistor of the shift register unit in the current stage has a large load, which results in a signal output delay. In addition, if the output transistor has a failure, not only a poor signal output would be generated in the gate line corresponding to the current stage, but also an output failure would occur in the gate lines in the previous stage and the next stage.

CN 104 700 812 A describes a shift register having a structure for a multistage connection and an array substrate grid drive device.

CN 104 700 814 A describes a shift register unit including a pull-up module, an input module, a pull-down control module, a pull-down module, a reset discharging module, a voltage dividing module, a holding module, and a far end pull-down module.

US 2009/040161 A1 describes a display apparatus including a panel part having a plurality of gate lines, a plurality of data lines, a plurality of pixels, a data driver and a gate driver part. US 2012/320008 A1 defines a shift register comprising shift register units, wherein the output of said shift register units is optimized by using an additional transistor.

### SUMMARY

It is an object of the present invention to provide a shift register unit, a gate line driving device comprising multiple stages of the shift register units, and a driving method, which can downsize an overall structure of the GOA, reduce power consumption, decrease signal delay, improve signal waveform, and also enhance reliability of the GOA circuit in entirety.

The object is achieved by the features of the respective independent claims. Further embodiments are defined in the corresponding dependent claims.

In the shift register unit, the gate line driving device, and the corresponding driving method according to the the present invention, the resetting of the pull-up node is delayed, and the turn-on time of the output transistor is extended; thus, the low level clock signal outputted during the extended turn-on time of the output transistor can be adopted to perform the pull-down control on the signal at the gate line, removing the large-size transistor dedicated to pull down the output terminal; the driving signal provided to the gate line corresponding to the shift register unit in the current stage is separated from the trigger signal provided to the shift register unit in the next stage and/or a reset signal provided to the shift register unit in the previous stage, so that the signal delay is reduced, the signal waveform is improved, and the affect, which is due to the failure occurring in the output transistor in the shift register unit in the current stage, over the entire gate driving device is decreased, enhancing the circuit reliability; meanwhile, when a failure occurs in the output transistor in the shift register unit in the current stage, it is easy to locate a point of failure according to the malfunction in the scanning of a corresponding gate line.

The scope of the invention is defined in the appended claims. Any reference to "embodiment(s)", "example(s)" or "aspect(s) of the invention" in this description not falling under the scope of the claims should be interpreted as illustrative example(s) for understanding the invention.

### BRIEF DESCRIPTION OF THE DRAWINGS

In order to more clearly illustrate the technical solutions of the embodiments of the present invention, hereinafter, the drawings necessary for illustration of embodiments of the present invention will be introduced briefly; the drawings described below are only some embodiments of the present invention, and should not be construed as limiting the present invention.
FIG. 1 illustrates a circuit structure of a known shift register unit;
FIG. 2 illustrates timing of relevant signals applicable to the known shift register unit;
FIG. 3 is a block diagram of a shift register unit according to an embodiment of the present disclosure;
FIG. 4 illustrates a circuit structure of a shift register unit according to an embodiment of the present disclosure;
FIG. 5 illustrates timing of relevant signals applicable to the shift register unit according to the embodiment of the present disclosure;
FIG. 6A is a schematic diagram of a overall connection structure of a gate driving device according to an embodiment of the present disclosure;
FIG. 6B is a schematic diagram of timing of clock signals applicable to the gate line driving circuit illustrated in FIG. 6A; and
FIG. 7 a flowchart of a driving method applicable to a shift register unit according to an embodiment of the present disclosure.

### DETAILED DESCRIPTION OF THE EMBODIMENTS

Hereinafter, technical solutions in the embodiments of the present disclosure will he described clearly and comprehensively in combination with the drawings. Obviously, these described embodiments are merely parts of the embodiments of the present disclosure, rather than all of the embodiments thereof. Other embodiments obtained by a person of ordinary skill in the art based on the embodiments of the present disclosure without paying creative effort all fall into the protection scope of the present disclosure.

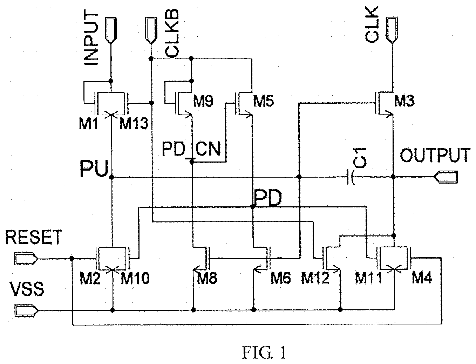

FIG. 1 illustrates a circuit structure of a known shift register unit. As illustrated in FIG. 1, the shift register unit comprises: an input transistor M1, a gate and a drain of the input transistor M1 being connected together and connected to an input terminal of the shift register unit, and a source of the input transistor M1 being connected to a pull-up node PU; an output transistor M3, a gate of the output transistor M3 being connected to the pull-up node PU, a drain of the output transistor M3 being connected to a first clock signal CLK, and a source of the output transistor M3 being connected to an output terminal of the shift register unit; a capacitor C1 connected in parallel between the gate and the source of the output transistor M3; a pull-up node reset transistor M2, a gate of the pull-up node reset transistor M2 being connected to a reset terminal of the shift register unit, a drain of the pull-up node reset transistor M2 being connected to the pull-up node, and a source of the pull-up node reset transistor M2 being connected to a low level input terminal VSS; an output reset transistor M4, a gate of the output reset transistor M4 being connected to the reset terminal of the shift register unit, a drain of the output reset transistor M4 being connected to the output terminal of the shift register unit, and a source of the output reset transistor M4 being connected to the low level input terminal VSS; a pull-up node level control transistor M10, a gate of the pull-up node level control transistor M10 being connected to a pull-down node PD, a drain of the pull-up node level control transistor M10 being connected to the pull-up node PU, and a source of the pull-up node level control transistor M10 being connected to the low level input terminal VSS; output-terminal level control transistors M11 and M12, a gate of the transistor M11 being connected to the pull-down node PD, a drain of the transistor M11 being connected to the output terminal of the shift register unit, and a source of the transistor M11 being connected to the low level input terminal VSS; a gate of the M12 being connected to a second clock signal terminal, a drain of the transistor M12 being connected to the output terminal of the shift register unit, and a source of the transistor M12 being connected to the low level input terminal VSS; a transistor M13, a gate of the transistor M13 being connected to the second clock signal terminal, a drain of the transistor M13 being connected to the input terminal of the shift register unit, and a source of the transistor M13 being connected to the pull-up node; a pull-down node control module, comprising transistors M9, M5, M8, and M6, a gate and a drain of the transistor M9 being connected to the second clock signal terminal, and a source of the transistor M9 being connected to a pull-down control node PD_CN; a gate of the transistor M5 being connected to the pull-down control node PD_CN, a drain of the transistor M5 being connected to the second clock signal terminal, and a source of the transistor M5 being connected to the pull-down node PD; a drain of the transistor M8 being connected to the pull-down control node PD_CN, a gate of the transistor M8 being connected to the pull-up node PU, and a source of the transistor M8 being connected to the low level input terminal VSS; a gate of the transistor M6 being connected to the pull-up node PU, a drain of the transistor M6 being connected to the pull-down node PD, and a source of the transistor M6 being connected to the low level input terminal VSS.

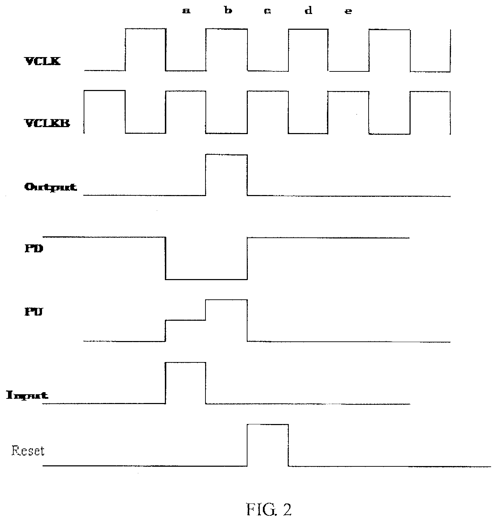

Operation principles of the shift register unit illustrated in FIG. 1 will be described below with reference to the signal timing illustrated in FIG. 2. In the five periods indicated by *a, b, c, d,* and *e* as illustrated in FIG. 2, the shift register unit performs the following operations:
In a first period *a,* a low level clock signal VCLK is inputted to the first clock signal terminal, a high level clock signal VCLKB is inputted to the second clock signal terminal, and a high level active input signal is connected to the input terminal INPUT; since a high level is inputted to the input terminal, the transistor M1 is turned on, so that the high level input signal charges the pull-up node PU; since the clock signal VCLKB is at a high level, the transistor M13 is turned on, so that charging process of the pull-up node is accelerated; the pull-up node PU is charged to a first high level; CLKB is at a high level, the transistor M12 is turned on, the output terminal of the shift register unit is pulled down to a low level VSS, which eliminates the noise in the output of the shift register unit; the transistor M9 is turned on to charge the pull-down control node PD_CN, so that the transistor M5 is turned on; since the pull-up node PU is at the first high level, the transistors M6 and M8 are turned on; in the design of transistors, a size ratio of the transistors M8 and M9 can be configured in such way that when M9 and M8 are both turned on, a level at the pull-down control node PD_CN is pulled down to a low level; likewise, a size ratio of the transistor M6 and M5 can be configured in such way that when M5 and M6 are both turned on, a level at the pull-down node is pulled down to a low level, thus ensuring that the transistors M10 and M11 are in a turned-off state in this period;
In a second period *b,* a high level clock signal VCLK is inputted to the first clock signal terminal, a low level clock signal VCLKB is inputted to the second clock signal terminal, and a low level is connected to the input terminal INPUT; the transistors M1, M13, M9, M5, and M12 are turned off; the output transistor M3 is turned on to output a high level clock signal VCLK; due to the bootstrap effect of the storage capacitor C1, a level at the pull-up node PU is further increased to a second high level, so that the output transistor M3 is turned on more fully; since the pull-up node PU is at a high level, the transistors M8 and M6 continue to be turned on, and the pull-down control node PD_CN and the pull-down node PD are pulled down to VSS, respectively; since the pull-down node PD is at a low level, the transistors M10 and M11 are maintained in a turned-off state, so that the normal output of a shift signal from the shift register unit cannot be affected;
In a third stage c, a low level clock signal VCLK is inputted to the first clock signal terminal, a high level clock signal VCLKB is inputted to the second clock signal terminal, a low level continues to be connected to the input terminal INPUT, and a high level is connected to the reset terminal; since a high level is connected to the reset terminal, the transistors M2 and M4 are turned on, the pull-up node PU and the output terminal of the shift register unit are pulled down to the low level VSS, respectively; the transistor M1 is turned off, and the transistor M13 is turned on, so that a low level is connected to the pull-up node PU, to discharge the pull-up node PU; the pull-up node PU is discharged to a low level, the transistor M3 is turned off; CLKB is at a high level, and the transistor M12 is turned on, so that the output terminal of the shift register unit is pulled down to the low level VSS, which eliminates the noise in the output of the shift register unit; the transistor M9 is turned on to charge the pull-down control node PD_CN, so that the transistor M5 is turned on to charge the pull-down node PD; since the pull-up node PU is at a low level, the transistors M6 and M8 are turned off; the pull-down node PD is charged to a high level, the transistors M10 and M11 are turned on, and the pull-up node PU and the output terminal of the shift register unit are pulled down to the low level VSS, respectively, which further eliminates the noises that might be generated at the output terminal and the pull-up node of the shift register unit in a non-output period.

In a fourth period *d*, a high level clock signal VCLK is inputted to the first clock signal terminal, a low level clock signal VCLKB is inputted to the second clock signal terminal, a low level continues to be connected to the input terminal INPUT, and a low level is connected to the reset terminal; the transistors M1, M13, M2, M4, M9, M5, and M12 are turned off; since the pull-up node PU be maintained at a low level, the transistors M6 and M8 continue to be turned off, and the pull-down node PD is at a high level, so that the transistors M10 and M11 are turned on, the pull-up node and the output terminal of the shift register unit are pulled down to the low level VSS, respectively, which eliminates the noises that might be generated at the output terminal and the pull-up node of the shift register unit in a non-output period.

In a fifth period *e,* a low level clock signal VCLK is inputted to the first clock signal terminal, a high level clock signal VCLKB is inputted to the second clock signal terminal, a low level continues to be connected to the input terminal INPUT, and a low level is connected to the reset terminal; the transistors M1, M2, and M4 are turned off; the transistor M13 is turned on, so that a low level is connected to the pull-up node PU, to discharge the pull-up node PU; the pull-up node PU is discharged to a low level, the transistor M3 is turned off; CLKB is at a high level, and the transistor M12 is turned on, so that the output terminal of the shift register unit is pulled down to the low level VSS, which eliminates the noise in the output of the shift register unit; the transistor M9 is turned on, to charge the pull-down control node PD_CN, so that the transistor M5 is turned on, so as to charge the pull-down node PD; since the pull-up node PU is at a low level, the transistors M6 and M8 are turned off; the pull-down node PD is maintained at a high level, the transistors M10 and M11 are turned on, so that the pull-up node and the output terminal of the shift register unit are pulled down to the low level VSS, respectively, which further eliminates the noises that might be generated at the output terminal and the pull-up node of the shift register unit in a non-output period.

In the shift register unit described above, since the transistor M4 functions only when the shift register unit in the current stage is reset (i.e., when a shift signal is outputted from an adjacent shift register unit in a next stage), and the transistor M4 is turned off in the other periods of the shift register unit in the current stage, its use time is short (it operates only in the period c described above), and its use efficiency is low. In addition, the transistor M4 is very large in size and occupies a lot of space, which results in unreasonable circuit structure, and it is difficult to achieve a narrow bezel for the overall product.

In addition, in the shift register unit described above, while outputting a signal to a gate line corresponding to the current stage, the output transistor M3 outputs a trigger signal for the shift register unit in a next stage and outputs a reset signal for the shift register unit in a previous stage, so that the load of the output transistor M3 is relatively large, which is easy to cause a signal delay; in addition, if the output transistor M3 has a failure, not only a scan failure would occur in a gate line corresponding to the shift register unit in the current stage, meanwhile a failure would occur in the shift register units in the previous stage and the next stage, which directly causes problems to a sequence of scan rows, so that the failure extends in the range and severity.

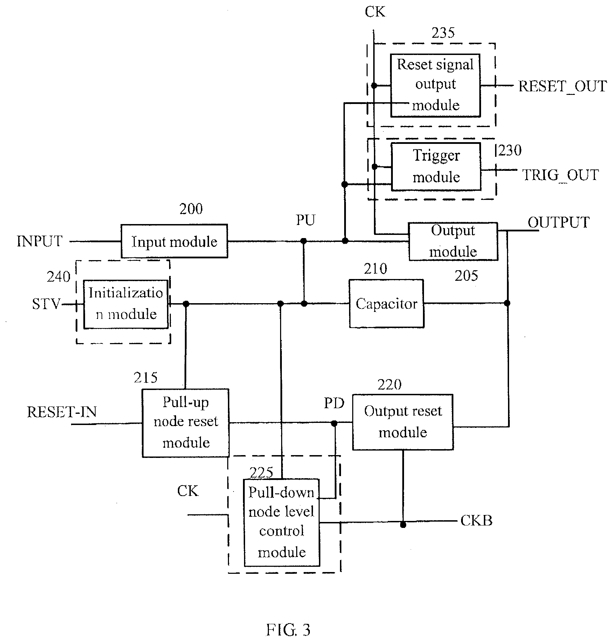

In view of the above, according to an aspect of the present disclosure, there is provided a shift register unit. As illustrated in FIG. 3, the shift register unit comprises: an input module 200 connected between an input terminal and a pull-up node PU, and configured to charge the pull-up node PU when a trigger signal from a previous stage is received at the input terminal; an output module 250 connected between the pull-up node PU, a first clock signal terminal CK and an output terminal, and configured to output a first clock signal at the first clock signal terminal CK to the output terminal under control of the pull-up node PU; a pull-up node reset module 215 connected between a reset terminal RESET-IN, a pull-down node PD and the pull-up node PU, and configured to reset the pull-up node PU under control of a reset signal at the reset tenninal RESET-IN or a level at the pull-down node PD; and an output reset module 220 connected between a second clock signal terminal CKB, the pull-down node PD and the output terminal, and configured to reset the output terminal under control of a second clock signal at the second clock signal terminal CKB or a level at the pull-down node PD.

As illustrated in FIG. 3, the shift register unit described above further comprises: a pull-down node level control module 225 connected between the first clock signal tenninal CK, the second clock signal terminal CKB, the pull-down node PD and the pull-up node PU, and configured to control a level at the pull-down node PD under control of at least one of the first clock signal at the first clock signal terminal CK, the second clock signal at the second clock signal terminal CKB, and a level at the pull-up node PU.

As illustrated in FIG. 3, the shift register unit described above further comprises: a trigger module 230 connected between the pull-up node PU and the first clock signal terminal CK, and configured to provide a trigger signal for a shift register unit in a next stage.

As illustrated in FIG. 3, the shift register unit described above further comprises: a reset signal output module 235 connected between the pull-up node PU and the first clock signal terminal CK, and configured to provide a reset signal for a shift register unit in a previous stage.

As illustrated in FIG. 3, the shift register unit described above further comprises: an initialization module 240 connected between an initial signal input terminal STV and the pull-up node PU, and configured to initialize a level at the pull-up node PU.

In the above-described shift register unit of the present disclosure, a module that provides a trigger signal to the shift register unit in a next stage and/or a module that provides a reset signal to the shift register unit in a previous stage are separated from a module that provides a driving signal to the gate line corresponding to the shift register unit in a current stage, so that the signal delay is reduced, and the affect, which is due to the failure occurring in the output module in the shift register unit in the current stage, over the entire gate driving device is decreased, enhancing the circuit reliability; meanwhile, when a failure occurs in the output module in the shift register unit in the current stage, it is easy to locate a point of failure according to the malfunction in the scanning of a corresponding gate line.

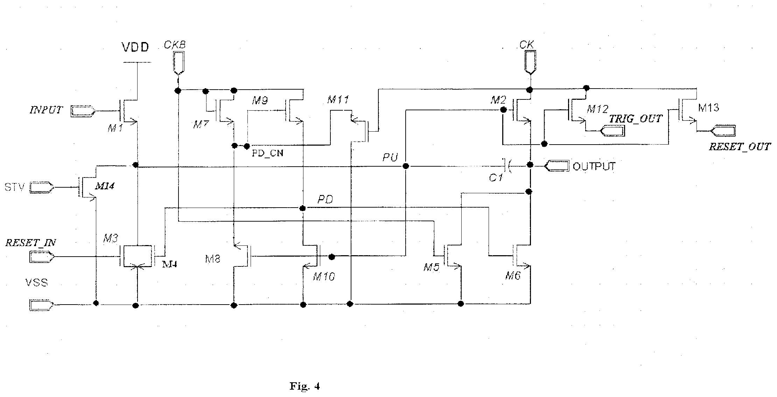

FIG. 4 illustrates a circuit structure of a shift register unit according to an embodiment of the present disclosure. The circuit structure of the shift register unit will be described in detail below in combination with FIGS. 2 and 4. As illustrated in FIG. 4, the input module comprises: a first transistor M1, a control electrode of the first transistor M1 being connected to the input terminal of the shift register unit, a first electrode of the first transistor M1 being connected to a first level input terminal VDD, and a second electrode of the first transistor M1 being connected to the pull-up node PU.

As illustrated in FIG. 4, the output module comprises: a second transistor M2, a control electrode of the second transistor M2 being connected to the pull-up node PU, a first electrode of the second transistor M2 being connected to the first clock signal terminal CK, and a second electrode of the second transistor M2 being connected to the output terminal; and a capacitor C1 connected in parallel with a gate and a source of the second transistor M2.

As illustrated in FIG. 4, the pull-up node reset module in the shift register unit comprises: a third transistor M3, a control electrode of the third transistor M3 being connected to the reset terminal RESET-IN, a first electrode of the third transistor M3 being connected to the pull-up node PU, and a second electrode of the third transistor M3 being connected to a second level input terminal VSS; and a fourth transistor M4, a control electrode of the fourth transistor M4 being connected to the pull-down node PD, a first electrode of the fourth transistor M4 being connected to the pull-up node PU, and a second electrode of the fourth transistor M4 being connected to the second level input terminal VSS.

As illustrated in FIG. 4, the output reset module in the shift register unit comprises: a fifth transistor M5, a control electrode of the fifth transistor M5 being connected to the second clock signal terminal CKB, a first electrode of the fifth transistor M5 being connected to the output terminal, and a second electrode of the fifth transistor M5 being connected to the second level input terminal VSS, and a sixth transistor M6, a control electrode of the sixth transistor M6 being connected to the pull-down node PD, a first electrode of the sixth transistor M6 being connected to the output terminal, and a second electrode of the sixth transistor M6 being connected to the second level input terminal VSS.

As illustrated in FIG. 4, the pull-down node level control module in the shift register unit comprises: a seventh transistor M7, a control electrode of the seventh transistor M7 being connected to a first electrode of the seventh transistor M7 and further connected to the second clock signal terminal CKB, a second electrode of the seventh transistor M7 being connected to a pull-down control node PD_CN; an eighth transistor M8, a control electrode of the eighth transistor M8 being connected to the pull-up node PU, a first electrode of the eighth transistor M8 being connected to the second level input terminal VSS, and a second electrode of the eighth transistor M8 being connected to the second electrode of the seventh transistor M7; a ninth transistor M9, a control electrode of the ninth transistor M9 being connected to the second electrode of the seventh transistor M7, a first electrode of the ninth transistor M9 being connected to the second clock signal terminal CKB, and a second electrode of the ninth transistor M9 being connected to the pull-down node PD; a tenth transistor M10, a control electrode of the tenth transistor M10 being connected to the pull-up node PU, a first electrode of the tenth transistor M10 being connected to the pull-down node PD, and a second electrode of the tenth transistor M10 being connected to the second level input terminal VSS; and an eleventh transistor M11, a control electrode of the eleventh transistor M11 being connected to the first clock signal terminal CK, a first electrode of the eleventh transistor M11 being connected to the second level input terminal VSS, and a second electrode of the eleventh transistor M11 being connected to a gate of the ninth transistor M9.

As illustrated in FIG. 4, the trigger module in the shift register unit comprises: a twelfth transistor M12, a control electrode of the twelfth transistor M12 being connected to the pull-up node PU, a first electrode of the twelfth transistor M12 being connected to the first clock signal terminal CK, and a second electrode of the twelfth transistor M12 being connected to a trigger signal output terminal.

As illustrated in FIG. 4, the reset signal output control module in the shift register unit comprises: a thirteenth transistor M13, a control electrode of the thirteenth transistor M13 being connected to the pull-up node PU, a first electrode of the thirteenth transistor M13 being connected to the first clock signal terminal CK, and a second electrode of the thirteenth transistor M13 being connected to the reset signal output terminal RESET OUT.

As illustrated in FIG. 4, the initialization module in the shift register unit comprises: a fourteenth transistor M14, a control electrode of the fourteenth transistor being connected to the initial signal input terminal STV, a first electrode of the fourteenth transistor being connected to the pull-up node PU, and a second electrode of the fourteenth transistor being connected to the second level input terminal VSS.

Although each of the transistors illustrated in FIG. 4 is an N-type transistor, the control electrode is the gate of the N-type transistor, the first electrode is the drain of the N-type transistor, the second electrode is the source of the N-type transistor; a high level VDD is connected to the first level input terminal, and a low level VSS is connected to the second level input terminal. However, in order to implement the principles of the present disclosure, it is also possible for a P-type transistor to be adopted for one or more of the transistors in the shift register unit described above, only if positions of the source and the drain are adjusted accordingly, and levels connected to the first level input terminal and the second level input terminal are adjusted accordingly, details will not be described here, but they should also be within the protection scope of the present disclosure.

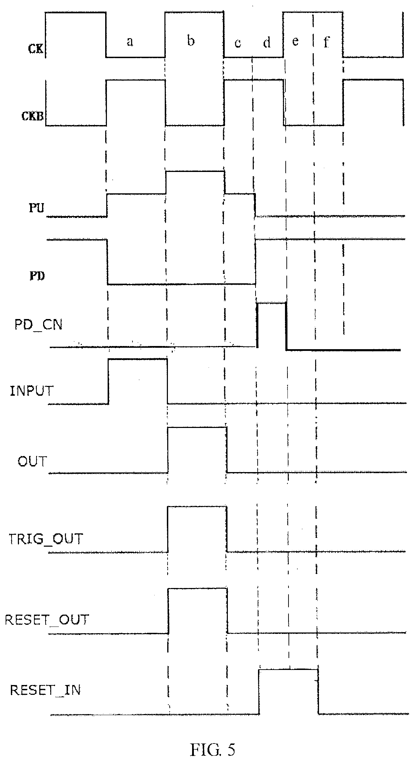

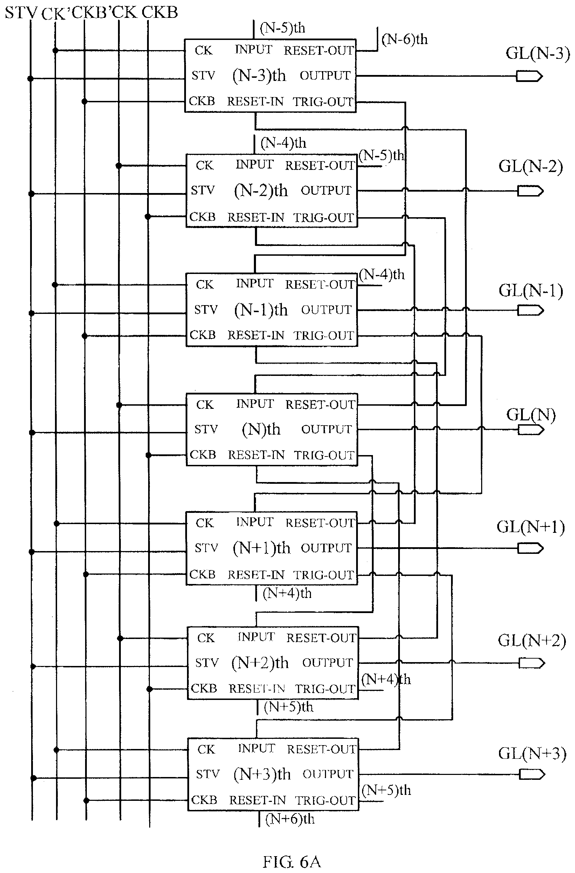

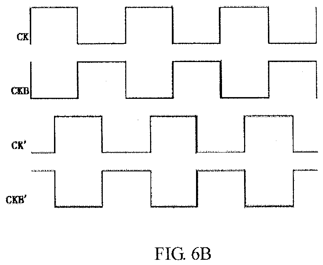

By taking the shift register unit illustrated in FIG. 4 as the shift register unit in an Nth stage of the gate line driving device illustrated in FIG. 6, the specific operation principles thereof will be described below with reference to the signal timing illustrated in FIG. 5. The first clock signal terminal of the shift register unit is connected to the first clock signal CK, the second clock signal terminal of the shift register unit is connected to the second clock signal CKB, the input terminal of the shift register unit is connected to a trigger signal output terminal of the shift register unit in a previous stage with one stage therebetween(i.e., the shift register unit in the (N-2)th stage), the trigger signal output terminal of the shift register unit is connected to an input terminal of a shift register unit in a next stage with one stage therebetween (i.e., the shift register unit in the (N+2)th stage), the reset signal output terminal of the shift register unit is connected to a reset terminal of the shift register unit in the previous stage with two stages therebetween (i.e., the shift register unit in the (N-3)th stage), the reset terminal of the shift register unit is connected to a reset signal output terminal of the shift register unit in a next stage with two stages therebetween (i.e., the shift register unit in the (N+3)th stage), and the output terminal of the shift register unit is connected to an Nth gate line GL(N). In the five periods indicated by *a, b, c, d,* and *e* illustrated in FIG. 5, the shift register unit performs the following operations:

In a first period *a,* a low level clock signal CK is inputted to the first clock signal terminal, a high level clock signal CKB is inputted to the second clock signal terminal, and a high level active input signal is connected to the input terminal INPUT; since a high level is inputted to the input terminal, the transistor M1 is turned on, so that the high level input signal charges the pull-up node PU; since the clock signal CKB is at a high level, the transistor M5 is turned on, so that the output terminal of the shift register unit is pulled down to a low level VSS, which eliminates the noise in the output of the shift register unit; the transistor M7 is turned on to charge the pull-down control node PD_CN, so that the transistor M9 is turned on; since the pull-up node PU is at the first high level, the transistors M8 and M10 are turned on; in the design of transistors, a size ratio of the transistors M8 and M7 can be configured in such a way that when M8 and M7 are both turned on, a level at the pull-down control node PD_CN is pulled down to a low level; likewise, a size ratio of the transistor M10 and M9 can be configured in such a way that when M10 and M9 are both turned on, a level at the pull-down node PD is pulled down to a low level, thus ensuring that the transistors M4 and M6 are in a turned-off state in this period;

In a second period *b,* a high level clock signal CK is inputted to the first clock signal terminal, a low level clock signal CKB is inputted to the second clock signal terminal, and a low level input signal is connected to the input terminal INPUT; the transistors M1, M7, and M5 are turned off; since CK is at a high level, the transistor M11 is turned on to pull down the pull-down control node PD_CN to VSS, and the transistor M9 is turned off; the output transistor M2 is turned on to output a high level clock signal CK, so as to output a driving signal to the corresponding gate line; because of bootstrap effect of the storage capacitor C1, a level at the pull-up node PU is further increased to a second high level, so that the output transistor M2 is turned on more fully; since the pull-up node PU is at a high level, the transistors M8 and M10 continue to be turned on, and the pull-down control node PD_CN and the pull-down node PD are pulled down to VSS, respectively; since the pull-down node PD is at a low level, the transistors M4 and M6 are maintained in a turned-off state, so as not to affect the normal output of a shift signal from the shift register unit; meanwhile, since the pull-up node is at a high level, the trigger transistor M12 is turned on, to output a trigger signal to the output terminal of the shift register unit in an (N+2)th stage; and the reset signal transistor M13 supplies a reset signal to the reset terminal of the shift register unit in an (N-3)th stage under control of the pull-up node that is at a high level.

In a third stage c, a low level clock signal CK is inputted to the first clock signal terminal, a high level clock signal CKB is inputted to the second clock signal terminal, a low level continues to be connected to the input terminal INPUT, the transistor M1 continues to be maintained off, the transistor M5 is turned on under control of the CKB that is at a high level, so that the output terminal of the shift register unit is pulled down to VSS, which eliminates the noise in the output of the shift register unit; the transistor M11 is turned off under control of the CK that is at a low level; the transistor M7 is turned on under control of CKB that is at a high level to charge the pull-down control node PD_CN, so that the transistor M9 is turned on to charge the pull-down node PD; in this case, since the signal connected to the reset signal terminal is still at a low level, the reset transistor M3 is not turned on, and the pull-up node PU is not pulled down to the low level VSS, and the output transistor M2 is maintained on; since the clock signal CK is changed from a high level to a low level, the output transistor M2 outputs the clock signal CK that is at a low level to the output terminal; due to the coupling effect of the capacitor C1, the level at the pull-up node PU is decreased from the second high level to the first high level, and is maintained at the first high level; since the pull-up node PU is maintained at the first high level, the transistors M8 and M10 are turned on; according to the size ratio of the transistors M8 and M7, when the transistor M8 and M7 are both turned on, the level at the pull-down control node PD_CN is pulled down to a low level; likewise, according to the size ratio of the transistors M10 and M9, when the transistor M10 and M9 are both turned on, the level at the pull-down node PD is pulled down to a low level, so as to ensure that the transistors M4 and M6 are in a turned-off state in this period.

In a fourth period *d*, still, a low level clock signal CK is still inputted to the first clock signal terminal, a high level clock signal CKB is inputted to the second clock signal terminal, and a low level continues to be connected to the input terminal INPUT, so that the transistor M1 continues to be maintained off, and the transistor M5 is maintained on under control of CKB that is at a high level, so that the output terminal of the shift register unit is pulled down to VSS, which eliminates the noise at the output of the shift register unit; the transistor M11 is maintained off under control of CK that is at a low level; the transistor M7 is maintained on under control of CKB that is at a high level, and the transistor M9 is maintained on; since the signal connected to the reset signal terminal is changed from a low level to a high level, the reset transistor M3 is turned on, to pull down the pull-up node PU from the first high level to the low level VSS, so that the output transistor M2 is turned off; since the pull-up node PU is pulled down to the VSS that is at a low level, the transistor M8 and M10 are turned off; since the transistors M7 and M9 are maintained on, the CKB signal that is at a high level charges the pull-down control node PD_CN and the pull-down node PD, so that the pull-down node PD is changed to a high level, and the transistors M4 and M6 are turned on, so as to pull down the pull-up node PU and the output terminal of the shift register unit to VSS, respectively, which eliminates the noise that might be generated at the output terminal and the pull-up node of the shift register unit.

In a fifth period e, a high level clock signal CK is inputted to the first clock signal terminal, a low level clock signal CKB is inputted to the second clock signal terminal, a low level continues to be connected to the input terminal INPUT, and a high level is connected to the reset terminal; the transistors M1, M7, M9, and M5 are turned off; since CK is at a high level, the transistor M11 is turned on, and the pull-down control node PD CN is pulled down to VSS; since the pull-up node PU is maintained at a low level, the transistors M8 and M10 continue to be turned off, the pull-down node PD is maintained at a high level, so that the transistors M4 and M6 are turned on, and the pull-up node and the output terminal of the shift register unit are pulled down to the low level VSS, respectively, which eliminates the noise that might be generated at the output terminal and the pull-up node of the shift register unit in a non-output period.

In a sixth period *f*, the clock signal CK at a high level continues to be inputted to the first clock signal terminal, the clock signal CKB at a low level continues to be inputted to the second clock signal terminal, a low level continues to be connected to the input terminal INPUT, and a low level is connected to the reset terminal; the transistors M1, M7, M9, M5, M3 are tuned off; since CK is at a high level, so that the transistor M11 is maintained on, and the pull-down control node PD_CN is maintained at the previous low level VSS; the pull-up node PU is maintained at the previous low level, and the transistors M8 and M10 are maintained off; the pull-down node PD is maintained at the previous high level, and the transistors M4 and M6 are turned on to pull down the pull-up node PU and the output terminal of the shift register unit to the low level VSS, which further eliminates the noise that might be generated at the output terminal and the pull-up node of the shift register unit in a non-output period.

Optionally, before the shift register unit performs the operations in the first period, firstly, a high level pulse signal is supplied to the initialization signal terminal STV of the shift register unit in a current stage, so as to turn on the transistor M14, so that a level at the pull-up node PU is initialized to a low level VSS.

In the shift register unit according to the embodiment of the present disclosure as illustrated in FIG. 4, the pull-down transistor M4 and the input transistor M13 in the shift register unit illustrated in FIG. 1 are removed, the area occupied by the large-size transistor M4 is reduced, which facilitates miniaturizing the gate drive circuit GOA and implementing narrow bezel of the display device; meanwhile, since connection structure of related circuit is changed, the resetting of the pull-up node is delayed, and the turn-on time of the output transistor M2 is extended; thus, the low level clock signal outputted during the extended turn-on time of the output transistor M2 can be adopted to perform the pull-down control on the signal at the gate line; in addition, since the size of the output transistor is larger than that of the removed transistor, it is more efficient to use the low level CK signal outputted from the output transistor to perform the pulling-down. In addition, the transistors M12 and the transistor M13 are arranged separately to provide a trigger signal for the shift register unit in the (N+2)th stage and a reset signal for the shift register unit in the (N-3)th stage, respectively, the driving signal provided to the gate line corresponding to the shift register unit in the current stage is separated from the trigger signal provided to the shift register unit in the (N+2)th stage and/or the reset signal provided to the shift register unit in the (N-3)th stage, so that the signal delay is reduced, the signal waveform is improved, and the affect, which is due to the failure occurring in the output transistor M2 in the shift register unit in the current stage, over the entire gate driving device is decreased, enhancing the circuit reliability; meanwhile, when a failure occurs in the output transistor in the shift register unit in the current stage, it is easy to locate a point of failure according to the malfunction in the scanning of a corresponding gate line.

According to another aspect of the present disclosure, there is further provided a gate driving device. As illustrated in FIG. 6, the gate line driving device comprises a plurality of shift register units cascaded in multiple stages, wherein the shift register unit in each stage can adopt the structure of the shift register unit illustrated in FIGS. 3 and 4. As illustrated in FIG. 6, an output terminal of the shift register unit in each stage is connected to one corresponding gate line; wherein the first clock signal terminal and the second clock signal terminal of the shift register unit in an odd-numbered stage are connected to the first clock signal CK and the second clock signal CKB, respectively; the trigger signal output terminal TRIG-OUT of the shift register unit in the odd-numbered stage is connected to an input terminal INPUT of the shift register unit in a next odd-numbered stage with one stage therebetween, the reset signal output terminal RESET-OUT of the shift register unit in the odd-numbered stage is connected to a reset terminal RESET-IN of the shift register unit in a previous even-numbered stage with two stages therebetween; the first clock signal terminal and the second clock signal terminal of the shift register unit in an even-numbered stage are connected to the third clock signal CK' and the fourth clock signal CKB', respectively; the trigger signal output terminal TRIG-OUT of the shift register unit in the even-numbered stage is connected to the input terminal INPUT of the next shift register unit in the even-numbered stage with one stage therebetween; the reset signal output terminal RESET-OUT of the shift register unit in the even-numbered stage is connected to the reset terminal RESET-IN of the shift register unit in odd-numbered stage with two stages therebetween. Periods of the first clock signal, the second clock signal, the third clock signal, and the fourth clock signal are the same, the timing of the first clock signal and that of second clock signal are opposite, and the timing of the third clock signal and that of the fourth clock signal are opposite, and the third clock signal lags behind the first clock signal by a quarter of the period. As illustrated in FIG. 6, taking the shift register unit in the Nth stage as an example, the output terminal OUTPUT of the shift register unit in the Nth stage is connected to the Nth gate line GL (N), the input terminal of the shift register unit in the Nth stage is connected to the trigger signal output terminal TRIG-OUT of the shift register unit in the (N-2)th stage; the trigger signal terminal TRIG-OUT of the Nth stage shift register unit is connected to the input terminal INPUT of the shift register unit in the (N+2)th stage, the reset signal output terminal RESET-OUT of the stage shift register unit in the Nth stage is connected to the reset terminal RESET-IN of the shift register in the (N-3)th stage, and the reset terminal RESET-IN of the Nth stage shift register unit is connected to the reset signal output terminal RESET-OUT of the shift register unit in the (N+3)th stage.

In the gate line driving device according to the present disclosure as described above, since the connection structure of the shift register unit is changed, the resetting of the pull-up node in the shift register unit is delayed, and the turn-on time of the output transistor is extended; thus, the low level clock signal outputted during the extended turn-on time of the output transistor can be adopted to perform the pull-down control on the signal at the gate line, achieving the pull-down more effectively; moreover, since the large-size transistor dedicated to pull down the output terminal is removed, it facilitates miniaturizing the gate driving device and implementing narrow bezel of the display device. In addition, a transistor to provide a trigger signal to the shift register unit in a next stage (in timing sequence) and/or a transistor to provide a reset signal to the shift register unit in a previous stage (in timing sequence) are arranged separately, the driving signal provided to the gate line corresponding to the shift register unit in the current stage is separated from the trigger signal provided to the shift register unit in the next stage and/or a reset signal provided to the shift register unit in the previous stage, so that the signal delay is reduced, the signal waveform is improved, and the affect, which is due to the failure occurring in the output transistor in the shift register unit in the current stage, over the entire gate driving device is decreased, enhancing the circuit reliability; meanwhile, when a failure occurs in the output transistor in the shift register unit in the current stage, it is easy to locate a point of failure according to the malfunction in the scanning of a corresponding gate line.

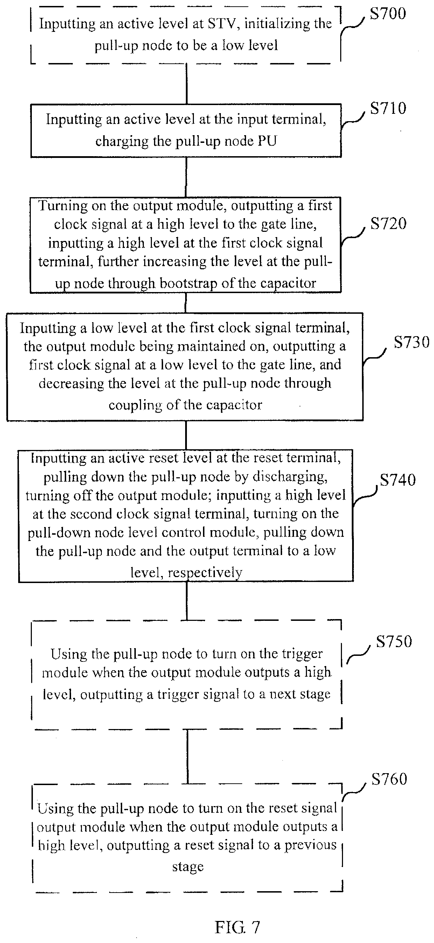

According to another aspect of the present disclosure, there is further provided a method for driving and controlling the shift register unit illustrated in FIG. 3. As illustrated in FIG. 7, the method mainly comprises the following steps: S710 inputting an active level to the input terminal, and charging the pull-up node to be at a first high level; S720 inputting a high level to the first clock signal terminal, and turning on the output module, and outputting a first clock signal at a high level to a gate line, so that a level at the pull-up node is increased from the first high level to a second high level through bootstrap effect of the capacitor; S730 inputting a low level to the first clock signal terminal, and maintaining the output module to be on, and outputting a first clock signal at a low level to the gate line, so that the level at the pull-up node is decreased from the second high level to the first high level through the coupling of the capacitor; S740 inputting an active reset level to the reset terminal, discharging the pull-up node to be at a low level, and turning off the output module; and charging the pull-down node by the high level inputted from the second clock signal terminal, and turning on the pull-down node level control module to pull down the pull-up node and the output terminal to be at a low level, respectively.

Optimally, the method described above further comprises step S700, inputting an active level to an initialization signal input terminal STV, so as to initialize the pull-up node to be at a low level.

The method described above further comprises step S750, turning on the trigger module by the pull-up node when the output module is turned on to output a first clock signal at a high level to a gate line, so as to output a trigger signal to the shift register unit in a next stage.

The method described above further comprises step S760, turning on the reset signal output module by the pull-up node when the output module is turned on to output a first clock signal at a high level to the gate line, so as to output a reset signal to the shift register unit in a previous stage.

Step S710 comprises: inputting a high level to the input terminal, and turning on the first transistor M1 to charge the pull-up node PU to be at a first high level.

Step S720 comprises: turning on the transistor M2 by the high level at the pull-up node PU, so that the transistor M2 outputs to the gate line a first clock signal at a high level, and the level at the pull-up node is further increased to a second high level through bootstrap effect of the capacitor C1.

Step S730 comprises: inputting a low level to the first clock signal terminal, and maintaining the transistor M2 on, so that the first clock signal at a low level is output to the gate line, and the level at the pull-up node is decreased to the first high level from the second high level through coupling effect of the capacitor C1.

Step S740 comprises: turning on the transistor M3 with the active reset level inputted from the reset terminal, and pulling down the pull-up node to be at the low level VSS, so that the transistor M2 is turned off; turning on the transistors M7 and M9 with the high level inputted from the second clock signal terminal, and pulling up the pull-down node PD to a high level, so that the transistors M4 and M6 are turned on and the pull-up node PU and the output terminal are pulled down.

Optionally, step S700 comprises: inputting an active level to the initialization signal input terminal STV, and turning on the transistor M14, so as to initialize the pull-up node to be at the low level VSS

Step S750 comprises: turning on the trigger transistor M12 with the high level at the pull-up node when the transistor M2 is turned on, so as to output a trigger signal to the shift register unit in a next stage.

Step S760 comprises: turning on the transistor M13 with the high level at the pull-up node when the transistor M2 is turned on, so as to output a reset signal to the shift register unit in a previous stage.

In the driving method for the shift register unit according to an embodiment of the present disclosure, the resetting of the pull-up node is delayed, and the turn-on time of the output transistor M2 is extended; thus, the low level clock signal outputted during the extended turn-on time of the output transistor can be adopted to perform the pull-down control on the signal at the gate line, removing the large-size transistor dedicated to pull down the output terminal; the driving signal provided to the gate line corresponding to the shift register unit in the current stage is separated from the trigger signal provided to the shift register unit in the next stage and/or a reset signal provided to the shift register unit in the previous stage, so that the signal delay is reduced, the signal waveform is improved, and the affect, which is due to the failure occurring in the output transistor M2 in the shift register unit in the current stage, over the entire gate driving device is decreased, enhancing the circuit reliability; meanwhile, when a failure occurs in the output transistor M2 in the shift register unit in the current stage, it is easy to locate a point of failure according to the malfunction in the scanning of a corresponding gate line.

## Claims

1. A gate line driving device comprising a plurality of shift register units cascaded in multiple stages, wherein a shift register unit comprises:
an input circuit (200) that comprises a first transistor (M1) having a control electrode connected to an input terminal (INPUT), a first electrode connected to a first level input terminal (VDD), and a second electrode connected to a pull-up node (PU);
an output circuit (250) that comprises a second transistor (M2) having a control electrode connected to the pull-up node (PU), a first electrode connected to a first clock signal terminal (CK), and a second electrode connected to an output terminal (OUTPUT);
a capacitor (C1) connected in parallel with a gate and a source of the second transistor (M2);
a pull-up node reset circuit (215) that comprises a third transistor (M3) having a control electrode connected to a reset terminal (RESET-IN), a first electrode connected to the pull-up node (PU), and a second electrode connected to a second level input terminal (VSS); and a fourth transistor (M4) having a control electrode connected to a pull-down node (PD), a first electrode connected to the pull-up node (PU), and a second electrode connected to the second level input terminal (VSS);
an output reset circuit (220) that comprises a fifth transistor (M5) having a control electrode connected to a second clock signal terminal (CKB), a first electrode connected to the output terminal (OUTPUT), and a second electrode connected to the second level input terminal (VSS), and a sixth transistor (M6) having a control electrode connected to the pull-down node (PD), a first electrode connected to the output terminal (OUTPUT), and a second electrode connected to the second level input terminal (VSS);
a pull-down node level control circuit (225) that comprises a seventh transistor (M7) having a control electrode connected to a first electrode thereof and further connected to the second clock signal terminal (CKB); an eighth transistor (M8) having a control electrode connected to the pull-up node (PU), a first electrode connected to the second level input terminal (VSS), and a second electrode connected to a second electrode of the seventh transistor (M7); a ninth transistor (M9) having a control electrode connected to the second electrode of the seventh transistor (M7), a first electrode connected to the second clock signal terminal (CKB), and a second electrode connected to the pull-down node (PD); a tenth transistor (M10) having a control electrode connected to the pull-up node (PU), a first electrode connected to the pull-down node (PD), and a second electrode connected to the second level input terminal (VSS); and an eleventh transistor (M11) having a control electrode connected to the first clock signal terminal (CK), a first electrode connected to the second level input terminal (VSS), and a second electrode connected to a gate of the ninth transistor (M9);
a trigger circuit (230) that comprises a twelfth transistor (M12) having a control electrode connected to the pull-up node (PU), a first electrode connected to the first clock signal terminal (CK), and a second electrode connected to a trigger signal output terminal (TRIG_OUT);
a reset signal output control circuit (235) that comprises a thirteenth transistor (M13) having a control electrode connected to the pull-up node (PU), a first electrode connected to the first clock signal terminal (CK), and a second electrode connected to a reset signal output terminal (RESET_OUT);
an initialization circuit (240) that comprises a fourteenth transistor (M14) having a control electrode connected to an initial signal input terminal (STV), a first electrode connected to the pull-up node (PU), and a second electrode connected to the second level input terminal (VSS);
wherein
the input circuit (200) is configured to charge the pull-up node (PU) when the trigger signal from a previous stage is received at the input terminal (INPUT);
the output circuit (205) is configured to output to the output terminal (OUTPUT) the first clock signal received at the first clock signal terminal (CK) under control of the pull-up node (PU);
the pull-up node reset circuit (215) is configured to reset the pull-up node (PU) under control of the reset signal inputted at the reset terminal (RESET-IN) or a level at the pull-down node (PD);
the output reset circuit (220) is configured to reset the output terminal (OUTPUT) under control of the second clock signal received at the second clock signal terminal (CKB) or a level at the pull-down node (PD);
the trigger circuit (230) is configured to provide the trigger signal to a shift register unit in a next stage,
the reset signal output circuit (235) is configured to provide the reset signal to a shift register unit in a previous stage;
the pull-down node level control circuit (225) is configured to control a level at the pull-down node (PD) under control of at least one of the first clock signal received at the first clock signal terminal (CK), the second clock signal received at the second clock signal terminal (CKB), and a level at the pull-up node (PU);
the initialization circuit (240)is configured to initialize a level at the pull-up node (PU),
**characterized in that**
an output terminal (OUTPUT) of the shift register unit in each stage is connected to one corresponding gate line (GL); wherein
the first clock signal terminal (CK) and the second clock signal terminal (CKB) of the shift register unit in an odd-numbered stage are connected to the first clock signal and the second clock signal, respectively;
the input terminal (INPUT) of the Nth stage shift register unit is connected to the trigger signal output terminal (TRIG-OUT) of the shift register unit in the (N-2)th stage;
the trigger signal output terminal (TRIG-OUT) of an Nth stage shift register unit is connected to the input terminal (INPUT) of the shift register unit in the (N+2)th stage, the reset signal output terminal (RESET-OUT) of the stage shift register unit in the Nth stage is connected to the reset terminal (RESET-IN) of the shift register in the (N-3)th stage, and the reset terminal (RESET-IN) of the shift register unit in the Nth stage is connected to the reset signal output terminal (RESET-OUT) of the shift register unit in the (N+3)th stage; the first clock signal terminal (CK) and the second clock signal terminal (CKB) of the shift register unit in an even-numbered stage are connected to a third clock signal and a fourth clock signal, respectively;
periods of the first clock signal, the second clock signal, the third clock signal, and the fourth clock signal are the same, a timing of the first clock signal and that of second clock signal are opposite, and the timing of the third clock signal and that of the fourth clock signal are opposite, and the third clock signal lags behind the first clock signal by a quarter of the period.

2. A driving method for being applied to each shift register unit of the gate line driving device according to claim 1, the method comprising:
(S710) inputting an active level to the input terminal (INPUT), turning on the input circuit (200), charging the pull-up node (PU) to be a first level, and turning on the output circuit (250) by the first level at the pull-up node (PU);
(S720) inputting an active level to the first clock signal terminal (CK), outputting a gate line turn-on voltage to a gate line (GL) connected to the output terminal (OUTPUT) by the output circuit (205) that is turned on, and changing the pull-up node (PU) from the first level to the second level;
(S730) inputting an inactive level to the first clock signal terminal (CK), maintaining the output circuit (205) to be on, so as to output a gate line turn-off voltage to the gate line (GL) connected to the output terminal (OUTPUT) and to change the pull-up node (PU) from the second level to the first level;
(S740) inputting an active level to the reset terminal (RESET-IN), turning on the pull-up node reset circuit (215), changing a level at the pull-up node (PU) to an inactive level, thereby turning off the output circuit (205);
charging the pull-down node (PD) by the active level inputted from the second clock signal terminal (CKB), turning on the output reset circuit (220) by the active level at the pull-down node (PD) and maintaining the pull-up node reset circuit (215) to be on, so as to maintain the output terminal (OUTPUT) and the pull-up node (PU) to be at the inactive level;
(S750) turning on the trigger circuit (230) with an active level at the pull-up node (PU) when the output circuit (205) is turned on, outputting a trigger signal to the shift register unit in a next stage; and
(S760) turning on the reset signal output circuit (235) with an active level at the pull-up node (PU) when the output circuit (205) is turned on, outputting a reset signal to the shift register unit in a previous stage.

## Patentansprüche

1. Gate-Leitungsansteuereinrichtung mit einer Vielzahl von in mehreren Stufen kaskadierten Schieberegistereinheiten, wobei eine Schieberegistereinheit aufweist:
eine Eingabeschaltung (200), die aufweist einen ersten Transistor (M1) mit einer Steuerelektrode, die mit einem Eingabeanschluss (INPUT) verbunden ist, einer ersten Elektrode, die mit einem Eingabeanschluss mit einem ersten Pegel (VDD) verbunden ist, und einer zweiten Elektrode, die mit einem Pull-up-Knoten (PU) verbunden ist;
eine Ausgabeschaltung (250), die aufweist einen zweiten Transistor (M2) mit einer Steuerelektrode, die mit dem Pull-up-Knoten (PU) verbunden ist, einer ersten Elektrode, die mit einem ersten Taktsignalanschluss (CK) verbunden ist, und einer zweiten Elektrode, die mit einem Ausgabeanschluss (OUTPUT) verbunden ist;
einen Kondensator (C1), der parallel zu einem Gate und einer Source des zweiten Transistors (M2) geschaltet ist;
eine Pull-up-Knoten-Rücksetzschaltung (215), die aufweist einen dritten Transistor (M3) mit einer Steuerelektrode, die mit einem Rücksetzanschluss (RESET-IN) verbunden ist, einer ersten Elektrode, die mit dem Pull-up-Knoten (PU) verbunden ist, und einer zweiten Elektrode, die mit einem Eingabeanschluss (VSS) mit einem zweiten Pegel verbunden ist; und einen vierten Transistor (M4) mit einer Steuerelektrode, die mit einem Pull-down-Knoten (PD) verbunden ist, einer ersten Elektrode, die mit dem Pull-up-Knoten (PU) verbunden ist, und einer zweiten Elektrode, die mit dem Eingabeanschluss (VSS) mit dem zweiten Pegel verbunden ist;
eine Ausgabe-Rücksetzschaltung (220), die aufweist einen fünften Transistor (M5) mit einer Steuerelektrode, die mit einem zweiten Taktsignalanschluss (CKB) verbunden ist, einer ersten Elektrode, die mit dem Ausgabeanschluss (OUTPUT) verbunden ist, und einer zweiten Elektrode, die mit dem Eingabeanschluss (VSS) mit dem zweiten Pegel verbunden ist, und einen sechsten Transistor (M6) mit einer Steuerelektrode, die mit dem Pull-down-Knoten (PD) verbunden ist, einer ersten Elektrode, die mit dem Ausgabeanschluss (OUTPUT) verbunden ist, und einer zweiten Elektrode, die mit dem Eingabeanschluss (VSS) des zweiten Pegels verbunden ist;
eine Pull-down-Knoten-Pegelsteuerschaltung (225), die aufweist einen siebten Transistor (M7) mit einer Steuerelektrode, die mit dessen ersten Elektrode verbunden ist und ferner mit dem zweiten Taktsignalanschluss (CKB) verbunden ist; einen achten Transistor (M8) mit einer Steuerelektrode, die mit dem Pull-up-Knoten (PU) verbunden ist, einer ersten Elektrode, die mit dem Eingabeanschluss (VSS) mit dem zweiten Pegel verbunden ist, und einer zweiten Elektrode, die mit einer zweiten Elektrode des siebten Transistors (M7) verbunden ist; einen neunten Transistor (M9) mit einer Steuerelektrode, die mit der zweiten Elektrode des siebten Transistors (M7) verbunden ist, einer ersten Elektrode, die mit dem zweiten Taktsignalanschluss (CKB) verbunden ist, und einer zweiten Elektrode, die mit dem Pull-down-Knoten (PD) verbunden ist; einen zehnten Transistor (M10) mit einer Steuerelektrode, die mit dem Pull-up-Knoten (PU) verbunden ist, einer ersten Elektrode, die mit dem Pull-down-Knoten (PD) verbunden ist, und einer zweiten Elektrode, die mit dem Eingabeanschluss (VSS) mit dem zweiten Pegel verbunden ist; und einen elften Transistor (M11) mit einer Steuerelektrode, die mit dem ersten Taktsignalanschluss (CK) verbunden ist, einer ersten Elektrode, die mit dem Eingabeanschluss (VSS) mit dem zweiten Pegel verbunden ist, und einer zweiten Elektrode, die mit einem Gate des neunten Transistors (M9) verbunden ist;
eine Trigger-Schaltung (230), die aufweist einen zwölften Transistor (M12) mit einer Steuerelektrode, die mit dem Pull-up-Knoten (PU) verbunden ist, einer ersten Elektrode, die mit dem ersten Taktsignalanschluss (CK) verbunden ist, und einer zweiten Elektrode, die mit einem Trigger-Signal-Ausgabeanschluss (TRIG OUT) verbunden ist;
eine Rücksetzsignal-Ausgabesteuerschaltung (235), die aufweist einen dreizehnten Transistor (M13) mit einer Steuerelektrode, die mit dem Pull-up-Knoten (PU) verbunden ist, einer ersten Elektrode, die mit dem ersten Taktsignalanschluss (CK) verbunden ist, und einer zweiten Elektrode, die mit einem Rücksetzsignal-Ausgabeanschluss (RESET_OUT) verbunden ist;
eine Initialisierungsschaltung (240), die aufweist einen vierzehnten Transistor (M14) mit einer Steuerelektrode, die mit einem Initialsignal-Eingabeanschluss (STV) verbunden ist, einer ersten Elektrode, die mit dem Pull-up-Knoten (PU) verbunden ist, und einer zweiten Elektrode, die mit dem Eingabeanschluss mit dem zweiten Pegel (VSS) verbunden ist;
wobei
die Eingabeschaltung (200) konfiguriert ist, den Pull-up-Knoten (PU) aufzuladen, wenn das Trigger-Signal von einer vorhergehenden Stufe am Eingabeanschluss (INPUT) empfangen wird;
die Ausgabeschaltung (205) konfiguriert ist, an den Ausgabeanschluss (OUTPUT) das erste Taktsignal auszugeben, das an dem ersten Taktsignalanschluss (CK) unter Steuerung des Pull-up-Knotens (PU) empfangen wird;
die Pull-Up-Knoten-Rücksetzschaltung (215) konfiguriert ist, den Pull-Up-Knoten (PU) unter Steuerung des an dem Rücksetzanschluss (RESET-IN) eingegebenen Rücksetz-Signals oder eines Pegels an dem Pull-Down-Knoten (PD) zurückzusetzen;
die Ausgabe-Rücksetzschaltung (220) konfiguriert ist, den Ausgabeanschluss (OUTPUT) unter Steuerung des zweiten Taktsignals, das an dem zweiten Taktsignalanschluss (CKB) empfangen wird, oder eines Pegels an dem Pull-down-Knoten (PD) zurückzusetzen;
die Trigger-Schaltung (230) konfiguriert ist, das Trigger-Signal in einer nächsten Stufe an eine Schieberegistereinheit zu liefern,
die Rücksetzsignal-Ausgabeschaltung (235) konfiguriert ist, das Rücksetzsignal an eine Schieberegistereinheit in einer vorhergehenden Stufe zu liefern;
die Pull-down-Knoten-Pegel-Steuerschaltung (225) konfiguriert ist, einen Pegel an dem Pull-down-Knoten (PD) unter der Steuerung von mindestens einem von dem ersten Taktsignal, das an dem ersten Taktsignalanschluss (CK) empfangen wird, dem zweiten Taktsignal, das an dem zweiten Taktsignalanschluss (CKB) empfangen wird, und einem Pegel an dem Pull-up-Knoten (PU) zu steuern;
die Initialisierungsschaltung (240) konfiguriert ist, einen Pegel an dem Pull-up-Knoten (PU) zu initialisieren,
**dadurch gekennzeichnet, dass**
ein Ausgabeanschluss (OUTPUT) der Schieberegistereinheit in jeder Stufe mit einer entsprechenden Gate-Leitung (GL) verbunden ist; wobei
der erste Taktsignalanschluss (CK) und der zweite Taktsignalanschluss (CKB) der Schieberegistereinheit in einer ungeradzahligen Stufe mit dem ersten Taktsignal bzw. dem zweiten Taktsignal verbunden sind;
der Eingabeanschluss (INPUT) der Schieberegistereinheit der N-ten Stufe mit dem Trigger-Signal-Ausgabeanschluss (TRIG-OUT) der Schieberegistereinheit in der (N-2)-ten Stufe verbunden ist;
der Trigger-Signal-Ausgabeanschluss (TRIG-OUT) einer Schieberegistereinheit der N-ten Stufe mit dem Eingabeanschluss (INPUT) der Schieberegistereinheit in der (N+2)-ten Stufe verbunden ist, der Rücksetzsignal-Ausgabeanschluss (RESET-OUT) der Schieberegistereinheit der N-ten Stufe mit dem Rücksetzanschluss (RESET-IN) des Schieberegisters in der (N-3)-ten Stufe verbunden ist, und der Rücksetzanschluss (RESET-IN) der Schieberegistereinheit in der N-ten Stufe mit dem Rückstellsignal-Ausgabeanschluss (RESET-OUT) der Schieberegistereinheit in der (N+3)-ten Stufe verbunden ist; der erste Taktsignalanschluss (CK) und der zweite Taktsignalanschluss (CKB) der Schieberegistereinheit in einer geradzahligen Stufe mit einem dritten Taktsignal bzw. einem vierten Taktsignal verbunden sind;
die Perioden des ersten Taktsignals, des zweiten Taktsignals, des dritten Taktsignals und des vierten Taktsignals gleich sind, eine Zeitsteuerung des ersten Taktsignals und die des zweiten Taktsignals entgegengesetzt sind, und die Zeitsteuerung des dritten Taktsignals und die des vierten Taktsignals entgegengesetzt sind, und das dritte Taktsignal um ein Viertel der Periode hinter dem ersten Taktsignal zurückbleibt.

2. Ansteuerverfahren zur Anwendung auf jede Schieberegistereinheit der Gate-LeitungsAnsteuereinrichtung gemäß Anspruch 1, wobei das Verfahren aufweist:
(S710) Eingeben eines aktiven Pegels in den Eingabeanschluss (INPUT), Einschalten der Eingabeschaltung (200), Laden des Pull-up-Knotens (PU) auf einen ersten Pegel und Einschalten der Ausgabeschaltung (250) durch den ersten Pegel am Pull-up-Knoten (PU);
(S720) Eingeben eines aktiven Pegels in den ersten Taktsignalanschluss (CK), Ausgeben einer Gate-Leitungs-Einschaltspannung an eine Gate-Leitung (GL), die durch die eingeschaltete Ausgabeschaltung (205) mit dem Ausgabeanschluss (OUTPUT) verbunden ist, und Ändern des Pull-up-Knotens (PU) von dem ersten Pegel auf den zweiten Pegel;
(S730) Eingeben eines inaktiven Pegels an den ersten Taktsignalanschluss (CK), wobei die Ausgabeschaltung (205) eingeschaltet bleibt, um eine Gate-Leitungs-Abschaltspannung an die mit dem Ausgabeanschluss (OUTPUT) verbundene Gate-Leitung (GL) auszugeben und den Pull-up-Knoten (PU) von dem zweiten Pegel auf den ersten Pegel zu ändern;
(S740) Eingeben eines aktiven Pegels an den Rücksetzanschluss (RESET-IN), Einschalten der Rücksetzschaltung (215) des Pull-up-Knotens, Ändern eines Pegels am Pull-up-Knoten (PU) auf einen inaktiven Pegel, wodurch die Ausgabeschaltung (205) abgeschaltet wird;
Laden des Pull-down-Knotens (PD) durch den aktiven Pegel, der von dem zweiten Taktsignalanschluss (CKB) eingegeben wird, Einschalten der Ausgabe-Rücksetzschaltung (220) durch den aktiven Pegel an dem Pull-down-Knoten (PD) und Aufrechterhalten, dass die Pull-up-Knoten-Rücksetzschaltung (215) eingeschaltet ist, um den Ausgabeanschluss (OUTPUT) und den Pull-up-Knoten (PU) auf dem inaktiven Pegel zu halten;
(S750) Einschalten der Trigger-Schaltung (230) mit einem aktiven Pegel am Pull-up-Knoten (PU), wenn die Ausgabeschaltung (205) eingeschaltet wird, Ausgeben eines TriggerSignals an die Schieberegistereinheit in einer nächsten Stufe; und
(S760) Einschalten der Rücksetzsignal-Ausgabeschaltung (235) mit einem aktiven Pegel an dem Pull-up-Knoten (PU), wenn die Ausgabeschaltung (205) eingeschaltet wird, wobei in einer vorhergehenden Stufe ein Rücksetzsignal an die Schieberegistereinheit ausgegeben wird.

## Revendications

1. Dispositif de pilotage de ligne de grille comprenant une pluralité d'unités de registre à décalage qui sont montées en cascade selon de multiples étages, dans lequel une unité de registre à décalage comprend :
un circuit d'entrée (200) qui comprend un premier transistor (M1) qui comporte une électrode de commande qui est connectée à une borne d'entrée (INPUT), une première électrode qui est connectée à une borne d'entrée de premier niveau (VDD) et une seconde électrode qui est connectée à un nœud d'excursion haute (PU) ;
un circuit de sortie (250) qui comprend un deuxième transistor (M2) qui comporte une électrode de commande qui est connectée au nœud d'excursion haute (PU), une première électrode qui est connectée à une borne de premier signal d'horloge (CK) et une seconde électrode qui est connectée à une borne de sortie (OUTPUT) ;
un condensateur (Cl) qui est connecté en parallèle à une grille et à une source du deuxième transistor (M2) ;
un circuit de réinitialisation de nœud d'excursion haute (215) qui comprend un troisième transistor (M3) qui comporte une électrode de commande qui est connectée à une borne de réinitialisation (RESET-IN), une première électrode qui est connectée au nœud d'excursion haute (PU) et une seconde électrode qui est connectée à une borne d'entrée de second niveau (VSS) ; et un quatrième transistor (M4) qui comporte une électrode de commande qui est connectée à un nœud d'excursion basse (PD), une première électrode qui est connectée au nœud d'excursion haute (PU) et une seconde électrode qui est connectée à la borne d'entrée de second niveau (VSS) ;
un circuit de réinitialisation de sortie (220) qui comprend un cinquième transistor (M5) qui comporte une électrode de commande qui est connectée à une borne de deuxième signal d'horloge (CKB), une première électrode qui est connectée à la borne de sortie (OUTPUT) et une seconde électrode qui est connectée à la borne d'entrée de second niveau (VSS), et un sixième transistor (M6) qui comporte une électrode de commande qui est connectée au nœud d'excursion basse (PD), une première électrode qui est connectée à la borne de sortie (OUTPUT) et une seconde électrode qui est connectée à la borne d'entrée de second niveau (VSS) ;
un circuit de commande de niveau de nœud d'excursion basse (225) qui comprend un septième transistor (M7) qui comporte une électrode de commande qui est connectée à sa première électrode et qui est en outre connectée à la borne de deuxième signal d'horloge (CKB) ; un huitième transistor (M8) qui comporte une électrode de commande qui est connectée au nœud d'excursion haute (PU), une première électrode qui est connectée à la borne d'entrée de second niveau (VSS) et une seconde électrode qui est connectée à une seconde électrode du septième transistor (M7) ; un neuvième transistor (M9) qui comporte une électrode de commande qui est connectée à la seconde électrode du septième transistor (M7), une première électrode qui est connectée à la borne de deuxième signal d'horloge (CKB) et une seconde électrode qui est connectée au nœud d'excursion basse (PD) ; un dixième transistor (M10) qui comporte une électrode de commande qui est connectée au nœud d'excursion haute (PU), une première électrode qui est connectée au nœud d'excursion basse (PD) et une seconde électrode qui est connectée à la borne d'entrée de second niveau (VSS) ; et un onzième transistor (M11) qui comporte une électrode de commande qui est connectée à la borne de premier signal d'horloge (CK), une première électrode qui est connectée à la borne d'entrée de second niveau (VSS) et une seconde électrode qui est connectée à une grille du neuvième transistor (M9) ;
un circuit de déclencheur (230) qui comprend un douzième transistor (M12) qui comporte une électrode de commande qui est connectée au nœud d'excursion haute (PU), une première électrode qui est connectée à la borne de premier signal d'horloge (CK) et une seconde électrode qui est connectée à une borne de sortie de signal de déclencheur (TRIG_OUT) ;
un circuit de commande de sortie de signal de réinitialisation (235) qui comprend un treizième transistor (M13) qui comporte une électrode de commande qui est connectée au nœud d'excursion haute (PU), une première électrode qui est connectée à la borne de premier signal d'horloge (CK) et une seconde électrode qui est connectée à une borne de sortie de signal de réinitialisation (RESET_OUT) ;
un circuit d'initialisation (240) qui comprend un quatorzième transistor (M14) qui comporte une électrode de commande qui est connectée à une borne d'entrée de signal initial (STV), une première électrode qui est connectée au nœud d'excursion haute (PU) et une seconde électrode qui est connectée à la borne d'entrée de second niveau (VSS) ;
dans lequel :
le circuit d'entrée (200) est configuré pour charger le nœud d'excursion haute (PU) lorsque le signal de déclencheur en provenance d'un étage précédent est reçu au niveau de la borne d'entrée (INPUT) ;
le circuit de sortie (205) est configuré pour émettre en sortie sur la borne de sortie (OUTPUT) le premier signal d'horloge qui est reçu au niveau de la borne de premier signal d'horloge (CK) sous la commande du nœud d'excursion haute (PU) ;
le circuit de réinitialisation de nœud d'excursion haute (215) est configuré pour réinitialiser le nœud d'excursion haute (PU) sous la commande du signal de réinitialisation qui est entré au niveau de la borne de réinitialisation (RESET-IN) ou sous la commande d'un niveau au niveau du nœud d'excursion basse (PD) ;
le circuit de réinitialisation de sortie (220) est configuré pour réinitialiser la borne de sortie (OUTPUT) sous la commande du deuxième signal d'horloge qui est reçu au niveau de la borne de deuxième signal d'horloge (CKB) ou sous la commande d'un niveau au niveau du nœud d'excursion basse (PD) ;
le circuit de déclencheur (230) est configuré pour appliquer le signal de déclencheur sur une unité de registre à décalage dans un étage suivant ;
le circuit de sortie de signal de réinitialisation (235) est configuré pour appliquer le signal de réinitialisation sur une unité de registre à décalage dans un étage précédent;
le circuit de commande de niveau de nœud d'excursion basse (225) est configuré pour commander un niveau au niveau du nœud d'excursion basse (PD) sous la commande d'au moins un signal et/ou niveau pris parmi le premier signal d'horloge qui est reçu au niveau de la borne de premier signal d'horloge (CK), le deuxième signal d'horloge qui est reçu au niveau de la borne de deuxième signal d'horloge (CKB) et un niveau au niveau du nœud d'excursion haute (PU) ;
le circuit d'initialisation (240) est configuré pour initialiser un niveau au niveau du nœud d'excursion haute (PU) ;
**caractérisé en ce que** :
une borne de sortie (OUTPUT) de l'unité de registre à décalage dans chaque étage est connectée à une ligne de grille correspondante (GL) ; dans lequel :
la borne de premier signal d'horloge (CK) et la borne de deuxième signal d'horloge (CKB) de l'unité de registre à décalage dans un étage de numéro impair sont respectivement connectées au premier signal d'horloge et au deuxième signal d'horloge ;
la borne d'entrée (INPUT) de l'unité de registre à décalage de N-ième étage est connectée à la borne de sortie de signal de déclencheur (TRIG-OUT) de l'unité de registre à décalage dans le (N-2)-ième étage ;
la borne de sortie de signal de déclencheur (TRIG-OUT) d'une unité de registre à décalage de N-ième étage est connectée à la borne d'entrée (INPUT) de l'unité de registre à décalage dans le (N+2)-ième étage, la borne de sortie de signal de réinitialisation (RESET-OUT) de l'unité de registre à décalage dans le N-ième étage est connectée à la borne de réinitialisation (RESET-IN) du registre à décalage dans le (N-3)-ième étage, et la borne de réinitialisation (RESET-IN) de l'unité de registre à décalage dans le N-ième étage est connectée à la borne de sortie de signal de réinitialisation (RESET-OUT) de l'unité de registre à décalage dans le (N+3)-ième étage ; la borne de premier signal d'horloge (CK) et la borne de deuxième signal d'horloge (CKB) de l'unité de registre à décalage dans un étage de numéro pair sont respectivement connectées à un troisième signal d'horloge et à un quatrième signal d'horloge ;
les périodes du premier signal d'horloge, du deuxième signal d'horloge, du troisième signal d'horloge et du quatrième signal d'horloge sont les mêmes, une temporisation du premier signal d'horloge et celle du deuxième signal d'horloge sont opposées, et la temporisation du troisième signal d'horloge et celle du quatrième signal d'horloge sont opposées, et le troisième signal d'horloge est en retard derrière le premier signal d'horloge d'un quart de la période.

2. Procédé de pilotage destiné à être appliqué à chaque unité de registre à décalage du dispositif de pilotage de ligne de grille selon la revendication 1, le procédé comprenant :
(S710) l'entrée d'un niveau actif sur la borne d'entrée (INPUT), l'activation du circuit d'entrée (200), la charge du nœud d'excursion haute (PU) de telle sorte qu'il soit à un premier niveau et l'activation du circuit de sortie (250) au moyen du premier niveau au niveau du nœud d'excursion haute (PU) ;
(S720) l'entrée d'un niveau actif sur la borne de premier signal d'horloge (CK), l'émission en sortie d'une tension d'activation de ligne de grille sur une ligne de grille (GL) qui est connectée à la borne de sortie (OUTPUT) au moyen du circuit de sortie (205) qui est activé et le passage du nœud d'excursion haute (PU) du premier niveau au second niveau ;
(S730) l'entrée d'un niveau inactif sur la borne de premier signal d'horloge (CK), le maintien du circuit de sortie (205) de telle sorte qu'il soit activé, de manière à émettre en sortie une tension de désactivation de ligne de grille sur la ligne de grille (GL) qui est connectée à la borne de sortie (OUTPUT) et de manière à faire passer le nœud d'excursion haute (PU) du second niveau au premier niveau ;
(S740) l'entrée d'un niveau actif sur la borne de réinitialisation (RESET-IN), l'activation du circuit de réinitialisation de nœud d'excursion haute (215), le passage d'un niveau au niveau du nœud d'excursion haute (PU) à un niveau inactif, d'où ainsi la désactivation du circuit de sortie (205) ;
la charge du nœud d'excursion basse (PD) au moyen du niveau actif qui est entré depuis la borne de deuxième signal d'horloge (CKB), l'activation du circuit de réinitialisation de sortie (220) au moyen du niveau actif au niveau du nœud d'excursion basse (PD) et le maintien du circuit de réinitialisation de nœud d'excursion haute (215) de telle sorte qu'il soit activé, de manière à maintenir la borne de sortie (OUTPUT) et le nœud d'excursion haute (PU) de telle sorte qu'ils soient au niveau inactif ;
(S750) l'activation du circuit de déclencheur (230) au moyen d'un niveau actif au niveau du nœud d'excursion haute (PU) lorsque le circuit de sortie (205) est activé, l'émission en sortie d'un signal de déclencheur sur l'unité de registre à décalage dans un étage suivant ; et
(S760) l'activation du circuit de sortie de signal de réinitialisation (235) au moyen d'un niveau actif au niveau du nœud d'excursion haute (PU) lorsque le circuit de sortie (205) est activé, l'émission en sortie d'un signal de réinitialisation sur l'unité de registre à décalage dans un étage précédent.
